Europäisches Patentamt

European Patent Office

Office européen des brevets

(11) Publication number: **0 323 685 B1**

(12) **EUROPEAN PATENT SPECIFICATION**

(45) Date of publication of patent specification: **01.07.92** (51) Int. Cl.5: **C23C 18/16**

(21) Application number: **88300082.0**

(22) Date of filing: **07.01.88**

(54) **Process for the production of molded articles having partial metal plating.**

(43) Date of publication of application:
**12.07.89 Bulletin 89/28**

(45) Publication of the grant of the patent:
**01.07.92 Bulletin 92/27**

(84) Designated Contracting States:
**DE FR GB IT NL**

(56) References cited:
**EP-A- 0 132 485**
**EP-A- 0 192 233**
**EP-A- 0 256 428**
**GB-A- 1 254 308**

(73) Proprietor: **SANKYO KASEI KABUSHIKI KAISHA**
**11-14, Kugayama 2-chome**
**Ota-ku Tokyo(JP)**

(72) Inventor: **Yumoto, Tetsuo**
**600-3, Arahata,**
**Tokorozawa-shi, Saitama-ken(JP)**

(74) Representative: **Jones, Michael Raymond et al**
**HASELTINE LAKE & CO. Hazlitt House 28**
**Southampton Buildings Chancery Lane**
**London WC2A 1AT(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to moulded articles, such as circuit boards connectors, etc., having partial metal plating, and a process for their production.

An early disclosure of a process for the production of partially metal plated products is to be found in GB 1254308. The process involves the two-step injection moulding of an article from two materials, one being a plateable material the other being an unplateable material. The parts to be metal plated are exposed in the moulded article which as a whole is subjected to various treatments in which the plateable material which is exposed in the moulded article is etched to promote adhesion of the metal, actuated by the application of a catalyst for the metal plating reaction and then metal plated. In order to obtain a good seal between the two materials of the moulded article this document teaches that the nature, in particular the flexibility and likelihood of shrinkage, of each material should be taken into account when determining the order in which the materials are moulded.

Further processes for the production of moulded products having partial metal plating have been disclosed in EP-A-0192233, which corresponds to the Japanese Patent Application having the laying-open No. 61-239694. This document specifies several production processes, of which two processes will be explained below.

The first process includes the steps of moulding articles, adhesion promotion and adherent metal plating.

In the moulding process an alternate two shot injection moulding is used. In the first shot, a first portion of the moulded article which is provided with the parts to be metal plated, e.g. the circuit pattern, is moulded using a first electrically insulating material, while in the second shot a supporting structure is formed around the first portion by using a second electrically insulating material. Polyethersulphone mixed with a catalyst can be used as the first electrically insulating material, an appropriate catalyst and filler material being palladium catalyst scattered on powdered aluminium silicate. The catalyst mixed in the electrically insulating material is catalytic for the electroless metal plating to be conducted for the adhesive metal plating of the moulded article. A desirable second electrically insulating material to be selected for the supporting structure is polyethersulphone (without catalyst).

In the adhesion promotion process, the surfaces of the moulded article are made microporous and hydrophilic and the catalyst on the surface is exposed. Accordingly all the flat, smooth and glittering surfaces of the moulded article are matted. After an initial metal plating process, the moulded article is passed through a vapour of dicholormethane, in which the matted hydrophilic surfaces of the support structure will be made flat, smooth and hydrophobic so that they are more resistant to metal plating and once again the article is returned to the metal plating solution. The reason why this kind of process is used is to avoid the situation where the palladium catalyst is not uniformly dispersed, and the surface layers of the circuit pattern are poorly provided with catalyst so that the catalytic function of the surfaces are not brought into full play.

In the second production process the moulded articles are formed by a two shot process, where not only the first electrically insulating material to be used in the first shot process for forming the parts to be metal plated, e.g. the circuit pattern, but also the second electrically insulating material to be used in the second shot moulding process for moulding the support structure are materials having no catalyst. The moulded articles are treated with etching solution for adhesion promotion, then a catalyst for metal plating is added and further is activated for electroless metal plating and then non-adhered catalyst is washed away from the support structure and finally the moulded article is subjected to copper plating by using a solution for electroless copper plating.

The processes mentioned above involve the following problems.

The first problem in the production process of the former case is that the palladium catalyst is mixed into the first electrically insulating material. Palladium is an expensive precious metal. It needs to be mixed in a large quantity in order to have a catalytic function for electroless metal plating, and accordingly, an economical production will be difficult. The second problem is that the former case makes the production process complicated and deteriorates the working efficiency, since the process for making the matted surfaces of the support structure flat and smooth is needed to be included in the process in addition to the need to make matt all the smooth surfaces of the articles in order to expose catalyst.

The problem in the production process of the latter case is that it requires additional work to wash away with spray the catalyst adhered to the portions other than those which it is desired to metal plate, e.g. the circuit pattern. That is to say, all the surfaces of the support structure, after activation of the moulded articles but before electroless copper plating must be washed. It is time-consuming to ensure the removal of the catalyst. Especially, the work to wash away the catalyst adhering to the surface of the border portion of the first material and the support structure takes much time and costs much labour and is practically difficult. In the case when the removal of the catalyst is incomplete in the moulded articles, for instance, in the circuit boards, the portions other than circuit portions will be sure to get metal plated, and the insulation of these portions is not secured. Therefore, they will not function correctly as circuit boards.

A further process for the production of partially metal plated moulded articles is known from EP-A-0256428, which was published after the priority date of this application. The process disclosed in this document is said to be an improvement on the processes disclosed in EP-A-0192233 and uses an amorphous resin compound as the first material and a crystalline resin compound as the second material. Catalyst may either be mixed in with the first material prior to moulding or applied to the exposed parts of first material after the second material have been moulded about it by a process of adhesion promotion and activation prior to metal plating. The bond between the first and second moulded articles is said to be improved by: preheating to a specified temperature the first material after moulding but before the moulding of the second material around it; restricting the time taken to mould the second article; texturing the first article; using the same generic resin for both the first and second materials; or drying the first and second materials before moulding.

According to the present invention there is provided a process for the production of a partially metal plated moulded article characterised in that the process comprises the following steps:

moulding a primary moulded article;

pretreating the surface of the primary moulded article by chemical roughening to increase its adhesive power;

applying an electroless metal plating catalyst to the surface of the primary moulded article;

moulding a secondary moulded article around the pretreated primary moulded article to form a moulded article in which the parts of the primary moulded article to be metal plated are exposed;

and metal plating the moulded article.

There is also provided a partially metal plated moulded article comprising a secondary moulded article arranged around a primary moulded article, the arrangement being such that parts of the primary moulded article are exposed in the moulded article, those parts being metal plated, the partially metal plated, moulded article being characterised in that the surface of the primary moulded article has been pretreated by chemical roughening to increase its adhesion power and has been provided with an electroless metal plating catalyst on its surface only before the secondary moulded article is arranged around it.

The process of the present invention may involve moulding the primary moulded article 1, conducting the pre-treatment of the primary moulded article by adding a catalyst such as palladium, gold, silver, platinum, etc. after roughening of the surfaces of the primary moulded article, forming the secondary moulded article 2 on the base of the primary moulded article where the portions 1a of the primary moulded article to be plated with metal are exposed, and plating the moulded article with metal.

In addition to plastics, also ceramics etc. can be used as raw material for forming the primary and the secondary moulded articles. Suitable plastics materials include not only single plastics materials, but also those mixed with filler such as glass fibre, potassium titanate fibre, and so on.

The pre-treatment mentioned above can be carried out by using a publicly known process.

In the case when the surfaces of the primary moulded article are soiled with mould removing agent or a fatty substance after forming of the primary moulded article, it is advisable to conduct the removal of that agent or fatty substance. The procedure for this will depend on the kind of plastics material, for instance in the case of a primary moulded article composed of polyamide resin, fat can be removed by means of such organic solvents as methylethyl ketone or acetone, or a surface active agent, etc.

A variety of etching solutions may be used in the pre-treatment process in order to improve the adhesion power of the plated metal. In the case of an article made of polyphenylene sulphide resin, etching solutions such as chromic acid/sulphuric acid, acidic ammonium fluoride/nitric acid and hydrofluoric acid/nitric acid are suitable.

In the case when the primary moulded article is made of a plastics material, the way of adding the catalyst may be a "catalyst → accelerator" method or "sensitizing → activating" method depending upon practicality. The former is a method for applying palladium to the surface of the primary moulded article by activation with an acid such as hydrochloric acid, sulphuric acid, etc. after maceration in a mixed catalytic solution of the tin and palladium family. The latter is the method, where, at first, a relatively strong reducing agent such as tin chloride, hypophosphorous acid, hydrazinium chloride, etc. is adsorbed on the surfaces of the primary moulded article, then the article is macerated in a catalytic solution that contains ions of precious metal such as gold and palladium and finally the precious metal is applied to the surfaces of the primary moulded article.

It is usual for either chemical copper plating or chemical nickel plating to be used in the metal plating process of the moulded article 2. However, if the moulded article is a wiring board, the desirable process will be copper plating

The present invention is advantageous as:

it provides an efficient and economical mass production process for partially metal plated, moulded articles having functions as circuit boards, connectors, etc., and not limited to articles in the field of decorative articles;

as it allows a minimal quantity of precious metal possible to be used by applying the catalyst only to the surface of the primary moulded article;

as it allows the step of washing away the catalyst to be eliminated;

as it makes it possible to secure the complete insulation of the portions other than the circuit portions, in the case when the moulded article is, for instance, a circuit board.

The special features of this invention will be more deeply understood with the explanation made as follows on the base of the drawings, in which:

Fig. 1 is a perspective view of a primary moulded article to be used for a circuit board;

Fig. 2 is a perspective view of a secondary moulded article of the circuit board;

Fig. 3 is an enlarged sectional view according to the line III-III of Fig. 2;

Fig. 4 is a perspective view of the circuit board as a product;

Fig. 5 is an enlarged sectional view according to the line V-V of Fig. 4.

Example 1

Primary moulding process

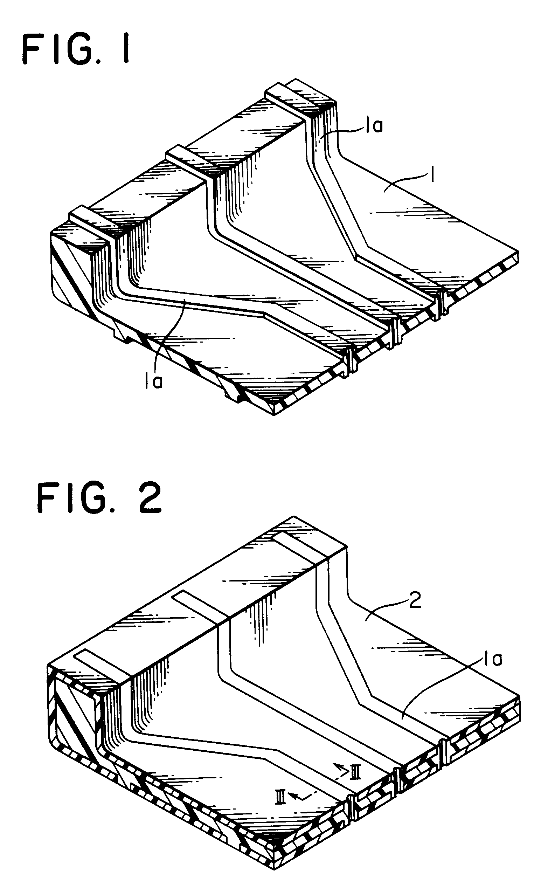

Primary moulded article 1 as shown in fig. 1 was moulded as a board by using a mould. A protruding pattern 1a was formed on the board.

Etching was conducted by macerating the board 1 for 5 minutes in an etching solution composed of acidic ammonium fluoride/nitric acid, at a temperature of 40°C, after subjecting the board 1 to a fat removing treatment.

After washing the board with water, sensitization with tin chloride and activation with palladium chloride were carried out and, after that, the drying of the board was conducted.

Secondary moulding process

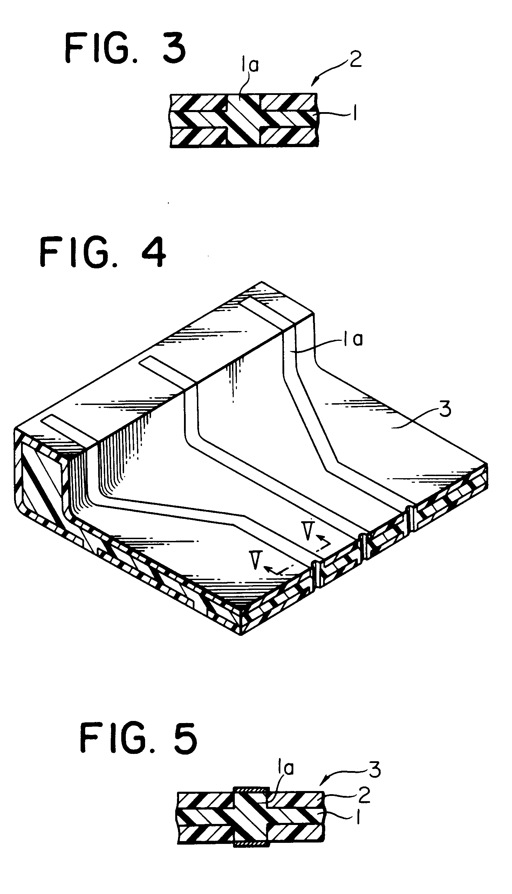

After drying, the board 1 was inserted into the cavity of a mould, then the cavity was filled with liquid plastic resin and a secondary moulded article 2 was formed as a board around the primary moulded article as shown in Fig. 2. As shown in Fig. 3, the pattern 1a of the board 1 protrudes outwards in the board 2. After the board 2 was subjected to a fat removing treatment, electroless metal plating was conducted to obtain a metal

thickness of 20μm. By doing so, the moulded plastic article was obtained as a circuit board 3, where only the pattern 1a of the outer surface of the circuit board was plated with metal as shown in Fig. 4 and Fig. 5.

In both the primary and secondary moulding processes, a thermoplastic resin mixture composed of 60 weight% of polyphenylene sulphide resin, 35 weight % of glass fibre and 5 weight % of potassium titrate fibre (Timos D made by Otsuka Chemical) was used as the raw material.

Example 2

A circuit board 3 was produced in the same way as Example 1. However, as raw material for the circuit board, a thermoplastic resin mixture composed of 70% of polyethersulphone resin and 30% of glass fibre was used.

Example 3

A circuit board was produced using a primary moulding process as that of Example 1. In the secondary moulding process after the secondary moulded article 2 had been moulded around the primary moulded article, it was treated with catalyst again, which adhered to the exposed parts 1a of the pretreated primary moulded article, and then plated with metal. By doing so, the adhering strength of the metal plating was improved.

Measurement of the adhesion state of the metal plated circuit pattern of each Example was carried out and showed that the adhering strength was strongest in the case of Example 3, followed by the case of Example 1.

**Claims**

1. A process for the production of a partially metal plated moulded article characterised in that the process comprises the following steps:
   moulding a primary moulded article;
   pretreating the surface of the primary moulded article by chemical roughening to increase its adhesive power;
   applying an electroless metal plating catalyst to the surface of the primary moulded article;
   moulding a secondary moulded article around the pretreated primary moulded article to form a moulded article in which the parts of the primary moulded article to be metal plated are exposed;
   and metal plating the moulded article.

2. A process according to claim 1, which further includes the step of applying further catalyst after the moulding of the secondary moulded article.

**3.** A process according to claim 1 or 2, wherein the pretreatment comprises etching with an etchant solution containing acidic ammonium fluoride/nitric acid.

**4.** A process according to claim 1, 2 or 3, wherein the primary moulded article is made of polyphenylene sulphide resin and the pretreatment comprises etching with an etchant solution containing chromic acid/sulphuric acid, acidic ammonium fluoride/nitric acid or hydrofluoric acid/nitric acid.

**5.** A partially metal plated, moulded article comprising a secondary moulded article arranged around a primary moulded article, the arrangement being such that parts of the primary moulded article are exposed in the moulded article, those parts being metal plated, the partially metal plated, moulded article being characterised in that the surface of the primary moulded article has been pretreated by chemical roughening to increase its adhesion power, and has been provided with an electroless metal plating catalyst on its surface only before the secondary moulded article is arranged around it.

**Revendications**

**1.** Un procédé pour la production d'un article moulé partiellement métallisé, caractérisé en ce que le procédé comprend les étapes suivantes:

moulage d'un article moulé primaire,

prétraitement de la surface de l'article moulé primaire par dégrossissage chimique pour augmenter son pouvoir d'adhérence,

application d'un catalyseur de métallisation non-électrique sur la surface de l'article moulé primaire,

moulage d'un article moulé secondaire autour de l'article moulé primaire prétraité pour former un article moulé dans lequel les parties de l'article moulé primaire à métalliser sont exposées,

et métallisation de l'article moulé.

**2.** Un procédé suivant la revendication 1, qui comprend, en outre, l'étape consistant à appliquer à nouveau du catalyseur après le moulage de l'article moulé secondaire.

**3.** Un procédé suivant la revendication 1 ou 2, dans lequel le prétraitement comprend le dérochage avec une solution de décapant contenant du fluorure d'ammonium acide/acide nitrique.

**4.** Un procédé suivant la revendication 1, 2 ou 3, dans lequel l'article moulé primaire est réalisé en résine sulfure de polyphénylène et le prétraitement comprend le dérochage avec une solution de décapant contenant de l'acide chromique/acide sulfurique, fluorure d'ammonium acide/acide nitrique ou acide fluorhydrique/acide nitrique.

**5.** Un article moulé partiellement métallisé comprenant un article moulé secondaire disposé autour d'un article moulé primaire, la disposition étant telle que des parties de l'article moulé primaire sont exposées dans l'article moulé, ces parties étant métallisées, l'article moulé partiellement métallisé étant caractérisé en ce que la surface de l'article moulé primaire a été prétraitée par dégrossissage chimique pour augmenter son pouvoir d'adhérence et n'a été pourvue d'un catalyseur de métallisation non-électrique sur sa surface qu'avant que l'article moulé secondaire ne soit disposé autour de celui-ci.

**Patentansprüche**

**1.** Verfahren zur Herstellung eines teilweise mit einem Metallüberzug versehenen Formteils, dadurch gekennzeichnet, daß das Verfahren folgende Schritte umfaßt:

Formen eines primären Formteils,

Vorbehandeln der Oberfläche des ursprünglichen Formteils durch chemisches Aufrauhen, um sein Haftvermögen zu erhöhen;

Aufbringen eines stromlosen Metallüberzugskatalysators auf die Oberfläche des primären Formteils,

Formen eines sekundären Formteils um den vorbehandelten primären Formteil herum, um ein Formteil zu bilden, bei dem die Teile des primären Formteils, das mit einem Metallüberzug zu versehen ist, offenliegen,

und Überziehen des Formteils mit Metall.

**2.** Verfahren nach Anspruch 1, dadurch gekennzeichnet, daß es weiterhin den Schritt umfaßt, daß nach dem Formen des sekundären Formteils ein weiterer Katalysator aufgebracht wird.

**3.** Verfahren nach Anspruch 1 oder 2, dadurch gekennzeichnet, daß die Vorbehandlung ein Ätzen mit einer Ätzmittellösung, die saures Ammoniumfluorid/Salpetersäure enthält, umfaßt.

4.   Verfahren nach Anspruch 1, 2 oder 3, dadurch gekennzeichnet, daß das primäre Formteil aus Polyphenylensulphidharz hergestellt ist und die Vorbehandlung ein Ätzen mit einer Ätzmittellösung umfaßt, die Chromsäure/Schwefelsäure, saures Ammoniumfluorid/Salpetersäure oder Fluorwasserstoffsäure/Salpetersäure enthält.

5.   Ein teilweise mit einem Metallüberzug versehenes Formteil, das ein um ein primäres Formteil herum angeordnetes, sekundäres Formteil umfaßt, wobei die Anordnung derart ist, daß Teile des primären Formteils in dem Formteil offenliegen, wobei diese Teile mit einem Metallüberzug versehen sind, und das teilweise mit einem Metallüberzug versehene Formteil dadurch gekennzeichnet ist, daß die Oberfläche des primären Formteils durch chemisches Aufrauhen vorbehandelt wurde, um sein Haftvermögen zu erhöhen, und erst mit einem stromlosen Metallüberzugskatalysator auf seiner Oberfläche versehen wird, bevor das sekundäre Formteil um es herum angeordnet wird.

# FIG. 1

# FIG. 2

## FIG. 3

## FIG. 4

## FIG. 5